# EUROPÄISCHE PATENTSCHRIFT

(11) **EP 1 215 774 B1**
(45) Veröffentlichungstag und Bekanntmachung des Hinweises auf die Patenterteilung: **19.11.2003**
(21) Anmeldenummer: 00127604.7
(22) Anmeldetag: 16.12.2000
(51) Int. Cl.: H01S 3/00, G02B 27/09, G02B 5/10

(54) **Koaxialer Laser mit einer Einrichtung zur Strahlformung eines Laserstrahls**
Device for shaping a laser beam
Dispositif pour la formation d'un faisceau laser

(43) Veröffentlichungstag der Anmeldung: 19.06.2002
(73) Patentinhaber: TRUMPF LASERTECHNIK GmbH, D-71254 Ditzingen (DE)
(72) Erfinder: Schulz, Joachim, 70193 Stuttgart (DE); Schlüter, Holger, West Hartford, CT 06107 (US)
(74) Vertreter: KOHLER SCHMID + PARTNER

(56) Entgegenhaltungen:
- DE-A- 4 421 600
- FR-A- 2 414 695
- US-A- 4 886 348
- MEINEL A B ET AL: "OPTICAL TESTING OF OFF-AXIS PARABOLIC SEGMENTS WITHOUT AUXILIARY OPTICAL ELEMENTS" OPTICAL ENGINEERING,US,SOC. OF PHOTO-OPTICAL INSTRUMENTATION ENGINEERS. BELLINGHAM, Bd. 28, Nr. 1, 1989, Seiten 71-75, XP000047062 ISSN: 0091-3286

## Beschreibung

Die Erfindung betrifft einen Laser, umfassend einen koaxialen Laserresonator mit ringförmigem Entladungsraum und ringsektorförmiger Auskoppelöffnung sowe eine Einrichtung zur Strahlformung des aus der Auskoppelöffnung austretenden Laserstrahls mit ringsektorförmigem Strahlquerschnitt in einen Laserstrahl mit rechteckförmigem Strahlquerschnitt, wobei die Einrichtung einen Spiegel aufweist, dessen Spiegeloberfläche als Ringsektor eines Rotationskörpers gestaltet ist.

Ein derartiger Laser ist beispielsweise durch die DE A-44 21 600 bekanntgeworden.

Der aus der DE-A-44 21 600 bekannte Laser umfasst eine Einrichtung zur Strahlformung, um aus einem ringsektorförmigen Laserstrahl mit radialer und/oder azimutaler Polarisation einen rechteckförmigen Laserstrahl mit linearer Polarisation zu erzeugen. Dazu wird der Laserstrahl von einem Kegelsektorspiegel und einem parabolischen Zylinderspiegel geformt, wobei der Linienfokus des parabolischen Zylinderspiegels mit der Rotationsachse des Kegelsektorspiegels annähernd zusammenfällt. Allerdings sind bei dieser bekannten Einrichtung zur Strahlformung zwei Spiegel erforderlich. Der Kegelsektorspiegel formt den Laserstrahl in azimutaler Richtung, zur Fokussierung oder Defokussierung des Laserstrahls in radialer Richtung ist ein zusätzlicher Spiegel erforderlich. Die auftretenden Brennweiten und Strahlabmessungen liegen in einer Größenordnung, dass bei sphärischen Spiegeln Abbildungsfehler durch sphärische Aberrationen auftreten. Um eine Auskopplung des Laserstrahls aus dem Laserresonator zu ermöglichen, ist es bei der bekannten Einrichtung zur Strahlformung mit einem Kegelsektorspiegel erforderlich, dass der Kegelöffnungswinkel geringfügig von 90° abweicht oder die Kegelachse nicht exakt mit dem Linienfokus des parabolischen Zylinderspiegels zusammenfällt. Dies hat zur Folge, dass der Strahlquerschnitt nur annähernd eine rechteckige Form und lineare Polarisation aufweist.

Es ist daher die Aufgabe der Erfindung, bei einem Laser der eingangs genannten Art die Einrichtung zur Strahlformung derart zu verbessern, dass Abbildungsfehler verringert werden.

Diese Aufgabe wird erfindungsgemäß dadurch gelöst, dass die Spiegeloberfläche als Ringsektor eines parabolischen Rotationskörpers gestaltet ist. Die Spiegeloberfläche kann durch die konvexe oder durch die konkave Oberfläche des parabolischen Rotationskörpers gebildet sein. Bevorzugt ist der parabolische Rotationskörper als Rotationsparaboloid ausgebildet.

Ein parabolischer Rotationskörper entsteht durch Rotation der Parabel z = x²/a², a² > 0 um eine beliebige, zur Symmetrieachse der Parabel parallele Rotationsachse. Die Krümmung der Parabel beträgt d²z/dx² = 2/a² und ist für a² > 0 überall von Null verschieden. Ein Ringsektor eines parabolischen Rotationskörpers kann auch durch einen elliptischen Rotationskörper approximiert werden. Ein Rotationsparaboloid stellt einen speziellen parabolischen Rotationskörper dar, bei dem die Rotationsachse mit der Symmetrieachse der Parabel zusammenfällt.

Spiegeloberflächen, die als Ringsektoren von parabolischen Rotationskörpern gestaltet sind, formen den Laserstrahl sowohl in azimutaler als auch in radialer Richtung. Abbildungsfehler durch sphärische Aberration treten bei derartigen Spiegeln grundsätzlich nicht auf, und bei exakter Parallelität zwischen Laserstrahlachse und optischer Achse sind sie auch frei von astigmatischen Abbildungsfehlern. Der Ringsektor eines parabolischen Rotationskörpers erzeugt einen Linienfokus auf seiner Rotationsachse, während der Ringsektor eines Rotationsparaboloiden einen Punktfokus auf seiner Rotationsachse erzeugt.

Wenn der Ringsektor des parabolischen Rotationskörpers koaxial zur Ringsektorachse des einfallenden Laserstrahls angeordnet ist und wenn der ringsektorförmige Laserstrahl am parabolischen Rotationskörper um 90° reflektiert wird, wird die radiale und/oder azimutale Polarisation in eine lineare Polarisation überführt. Die effektive Brennweite des Ringsektors des parabolischen Rotationskörpers entspricht in azimutaler Richtung dem Krümmungsradius des ringsektorförmigen Laserstrahls. Durch Reflexion am parabolischen Rotationskörper bzw. am Rotationsparaboloiden wird der ringsektorförmige Laserstrahl in einen rechteckförmigen Laserstrahl geformt, wobei der parabolische Rotationskörperspiegel auf seiner Rotationsachse einen Linienfokus und der Rotationsparaboloidspiegel auf seiner Rotationsachse einen Punktfokus erzeugt. Da die optische Achse parallel zur Laserstrahlachse verläuft, treten keine astigmatischen Abbildungsfehler auf, so dass insgesamt das Auftreten von Abbildungsfehlern verringert ist.

Vorzugsweise ist im Linienfokus des Ringsektors des parabolischen Rotationskörpers bzw. im Punktfokus des Ringsektors des Rotationsparaboloids eine Blende (Raumfilter) vorgesehen, die aus dem rechteckförmigen Laserstrahl unerwünschte Beugungsanteile (Nebenmaxima) ausblendet. Dabei kann die relative Position zwischen Blende und Linien- bzw. Punktfokus des Ringsektors verstellbar sein. Mittels einer Messeinrichtung kann die Temperatur der Blende erfasst und daraus ein Temperatursignal generiert werden, welches als Steuersignal zum Verstellen eines adaptiven Spiegels oder zum Verschieben der Blende dient.

Bei bevorzugten Ausführungsformen der Erfindung ist dem Ringsektor ein optisches Element mit einer oder mehreren Oberflächen nachgeordnet, die den Laserstrahl jeweils in zwei zueinander rechtwinkligen Richtungen formt bzw. formen. Mit diesem optischen Element können am Bearbeitungsort die gewünschten Strahlbreiten des Laserstrahls geformt werden.

In einer Weiterbildung dieser Ausführungsform ist das optische Element einteilig als Bifokuslinse ausgebildet, deren rückwärtiger Fokus vorzugsweise im Bereich der Rotationsachse des parabolischen Rotationskörpers liegt.

In einer anderen Weiterbildung ist das optische Element mehrteilig ausgebildet, beispielsweise durch eine Zylinderlinse und einen parabolische Zylinderspiegel oder durch eine Zylinderlinse und zwei parabolische Zylinderspiegel. Der rückwärtige Linienfokus der Zylinderlinse und/oder der rückwärtige Linienfokus des parabolischen Zylinderspiegels liegen bevorzugt im Bereich der Rotationsachse des parabolischen Rotationskörpers. Die Zylinderlinse kann den Laserresonator vakuumdicht abschließen und als Auskoppelfenster dienen. Ein parabolischer Zylinderspiegel kann auch durch einen elliptischen Zylinderspiegel approximiert sein.

Der Ringsektor des parabolischen Rotationskörpers und die Zylinderlinse können zusammen ein Galilei-Teleskop für die ursprünglich radiale, nunmehr entkrümmte Richtung des ringsektorf örmigen Laserstrahls, der Ringsektor des parabolischen Rotationskörpers und ein parabolischer Zylinderspiegel zusammen ein Kepler-Teleskop für die ursprünglich azimutale, nunmehr entkrümmte Richtung und die beiden parabolischen Zylinderspiegel zusammen ein Kepler-Teleskop für die ursprünglich azimutale Richtung bilden.

Bevorzugt ist der Ringsektor des parabolischen Rotationskörpers koaxial zur Ringsektorachse des einfallenden Laserstrahls ausgerichtet, d.h., die Rotationsachse des parabolischen Rotationskörpers fällt mit der Ringsektorachse des einfallenden Laserstrahls zusammen. Dadurch wird der ringsektorförmige Laserstrahl mit radialer und/oder azimutaler Polarisation in einen rechteckförmigen Laserstrahl mit linearer Polarisation geformt.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigt:
- Fig. 1: einen Laser mit einem koaxialen Laserresonator und einer erfindungsgemäßen Einrichtung zur Strahlformung des Laserstrahls;
- Fig. 2: einen Schnitt in nicht maßstäblicher Darstellung durch die in Fig. 1 gezeigte Einrichtung zur Strahlformung;
- Fig. 3: eine andere erfindungsgemäße Einrichtung zur Strahlformung des Laserstrahls in einer Darstellung analog der Fig. 1; und
- Fig. 4: einen Schnitt in nicht maßstäblicher Darstellung durch die in Fig. 3 gezeigte Einrichtung zur Strahlformung in einer Darstellung analog der Fig. 2.

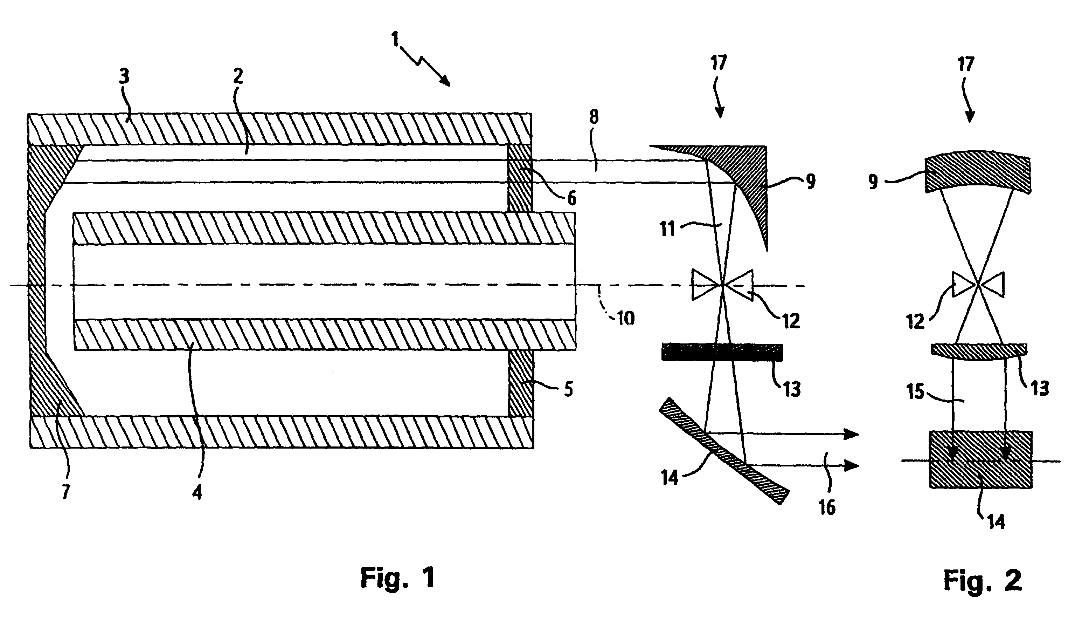

**Fig. 1** zeigt einen koaxialen Laserresonator 1 mit einem ringförmigen Entladungsraum **2**, der von einer zylindrischen Außenelektrode **3** und einer darin befindlichen zylindrischen Innenelektrode **4** begrenzt ist. An dem in Fig. 1 rechten Ende des Laserresonators 1 ist der ringförmige Entladungsraum 2 durch einen ringförmigen Frontspiegel **5** mit einer ringsektorförmigen Auskoppelöffnung **6** und am linken Ende durch einen konischen Rückspiegel **7** begrenzt.

Der durch die ringsektorförmige Auskoppelöffnung **6** aus dem ringförmigen Entladungsraum **2** austretende ringsektorförmige Laserstrahl **8** ist radial und/oder azimutal polarisiert. Außerdem enthält die Leistungsdichteverteilung unerwünschte Beugungsanteile (Nebenmaxima).

Der ringsektorförmige Laserstrahl **8** trifft innenseitig auf einen um 90° umlenkenden Ringsektor **9** eines Rotationsparaboloidspiegels, dessen Rotationsachse **10** koaxial zum ringförmigen Entladungsraum **2** und parallel zur Einfallsrichtung des Laserstrahls **8** liegt und dessen Brennweite in azimutaler Richtung dem Krümmungsradius des ringsektorförmigen Querschnitts des Laserstrahls **8** entspricht. Durch Reflexion am Ringsektor **9** des Rotationsparaboloids wird der ringsektorförmige Laserstrahl **8** in einen rechteckförmigen Laserstrahl **11** geformt (d.h. entkrümmt) und auf der Rotationsachse **10** ein Punktfokus erzeugt. Im Bereich dieses Punktfokus ist eine Blende **12**, insbesondere eine Düse, angeordnet, die unerwünschte Beugungsanteile aus dem rechteckförmigen Laserstrahl 11 ausblendet.

Damit der rechteckförmige Laserstrahl 11 am Bearbeitungsort die gewünschten Strahlbreiten in beiden Richtungen besitzt, werden zur Strahlformung in der ursprünglich azimutalen Richtung eine Zylinderlinse 13 und zur Strahlformung in der ursprünglich radialen Richtung ein parabolischer Zylinderspiegel **14**, der auch durch einen elliptischen Zylinderspiegel approximiert werden kann, eingesetzt. Der rechteckförmige Laserstrahl 11 trifft auf die Zylinderlinse **13**, die die ursprünglich radiale Richtung des rechteckförmigen Laserstrahls 11 nicht beeinflusst und einen parallelen Laserstrahl 15 in der ursprünglich azimutalen Richtung erzeugt (**Fig**. **2**). Der parabolische Zylinderspiegel 14 ist so im Strahlengang angeordnet, dass sich sein rückwärtiger Linienfokus etwa im Bereich der Rotationsachse 10 befindet. Durch geeignete Wahl der Brennweite des parabolischen Zylinderspiegels 14 wird ein radial paralleler Laserstrahl **16** mit der gewünschten radialen Strahlbreite erzeugt.

Der Ringsektor 9, die Blende 12, die Zylinderlinse 13 und der parabolische zylinderspiegel 14 bilden zusammen die insgesamt mit 17 bezeichnete Einrichtung zur Strahlformung.

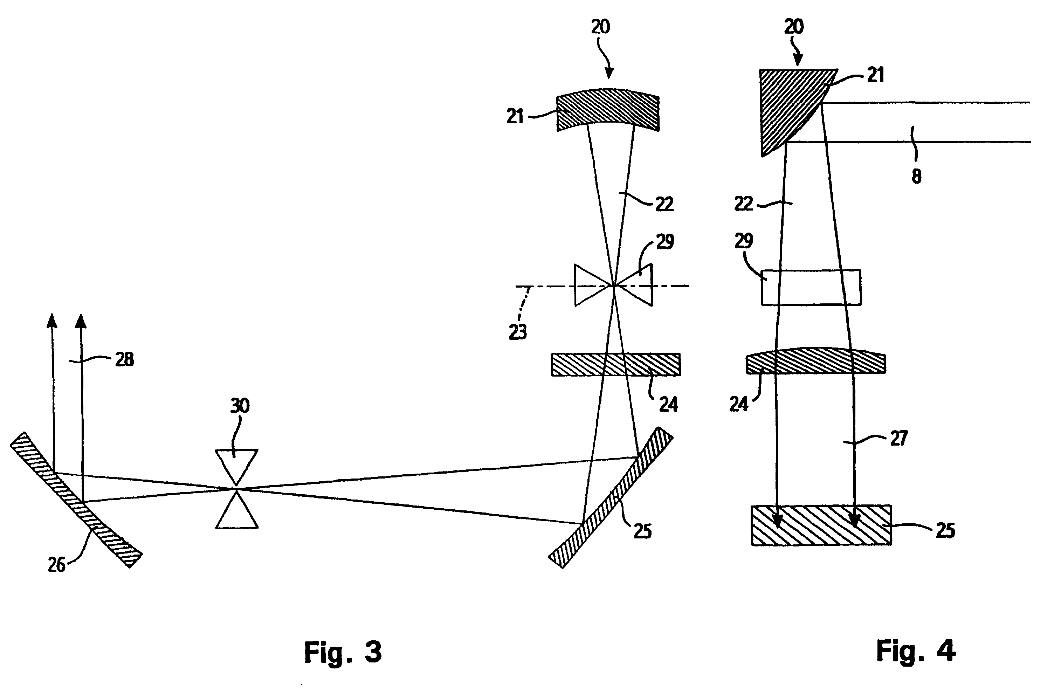

**Fig. 3** und **Fig. 4** zeigen eine andere Einrichtung **20** zur Strahlformung, bei der der ringsektorförmige Laserstrahl **8** außenseitig auf den Ringsektor **21** eines parabolischen Rotationskörpers trifft. Durch Reflexion an der konvexen Außenoberfläche des Ringsektors 21 wird der ringsektorförmige Laserstrahl 8 in einen rechteckförmigen Laserstrahl **22** geformt, wobei auf der Rotationsachse **23** des parabolischen Rotationskörpers ein Linienfokus erzeugt wird.

Damit der rechteckförmige Laserstrahl **22** am Bearbeitungsort die gewünschten Strahlbreiten in beiden Richtungen besitzt, werden zur Strahlformung in der ursprünglich radialen Richtung eine Zylinderlinse **24** und zur Strahlformung in der ursprünglich azimutalen Richtung zwei parabolische Zylinderspiegel **25**, **26** eingesetzt. Der Ringsektor 21 des parabolischen Rotationskörperspiegels bildet mit der Zylinderlinse 24 ein Galilei-Teleskop, das in der ursprünglich radialen Richtung einen parallelen Laserstrahl **27** erzeugt, und mit dem ersten parabolischen Zylinderspiegel 25 ein Kepler-Teleskop. Die beiden parabolischen Zylinderspiegel 25, 26 stellen zusammen ein weiteres Kepler-Teleskop für die ursprünglich azimutale Richtung dar, das in der ursprünglich azimutalen Richtung einen parallelen Laserstrahl **28** erzeugt. Der rechteckförmige Laserstrahl 22 trifft auf die Zylinderlinse 24, die so im Strahlengang angeordnet ist, dass sich ihr rückwärtiger Linienfokus etwa im Bereich der Rotationsachse 23 befindet. Durch geeignete Wahl der Brennweite der Zylinderlinse 24 wird der Laserstrahl 27 mit der in der ursprünglich radialen Richtung gewünschten Strahlbreite erzeugt (Fig. 4). Die andere, urspünglich azimutale Richtung des Laserstrahls 22 wird durch die Zylinderlinse 24 nicht beeinflusst. Anschließend trifft der Laserstrahl 27 auf den parabolischen Zylinderspiegel 25, der die ursprünglich radiale Richtung des Laserstrahls 22 nicht beeinflusst.

Um Beugungsanteile aus dem rechteckförmigen Laserstrahl 22 auszublenden, kann entweder eine Blende **29** im Bereich des Linienfokus des Ringsektors 21 des parabolischen Rotationskörpers oder eine Blende **30** im Bereich des Linienfokus des ersten parabolischen Zylinderspiegels 25 angeordnet sein.

Eine Einrichtung **17** zur Formung eines Laserstrahls 8 mit ringsektorförmigem Strahlquerschnitt in einen Laserstrahl 11 mit rechteckförmigem Strahlquerschnitt umfasst einen Spiegel, dessen Oberfläche als Ringsektor **9** eines reflektierenden eines parabolischen Rotationskörpers gestaltet ist. So kann mit nur einem einzigen Spiegel und mit geringen Abbildungsfehlern der ringsektorförmige Laserstrahl 8 in einen rechteckförmigen Laserstrahl 11 geformt werden.

## Patentansprüche

1. Laser, umfassend einen koaxialen Laserresonator (1) mit ringförmigem Entladungsraum (2) und ringsektorförmiger Auskoppelöffnung (6) sowie eine Einrichtung (17; 20) zur Strahlformung des aus der Auskoppelöffnung (6) austretenden Laserstrahls (8) mit ringsektorförmigem Strahlquerschnitt in einen Laserstrahl (11) mit rechteckförmigem Strählquerschnitt, wobei die Einrichtung (17; 20) einen Spiegel aufweist, dessen Spiegeloberfläche als Ringsektor (9; 21) eines Rotationskörpers gestaltet ist,
**dadurch gekennzeichnet,**
**dass** die Spiegeloberfläche als Ringsektor (9; 21) eines parabolischen Rotationskörpers gestaltet ist.

2. Laser nach Anspruch 1, **dadurch gekennzeichnet, dass** die Spiegeloberfläche durch die konvexe oder die konkave Oberfläche des parabolischen Rotationskörpers gebildet ist.

3. Laser nach Anspruch 2, **dadurch gekennzeichnet, dass** der parabolische Rotationskörper als Rotationsparaboloid ausgebildet ist.

4. Laser nach einem der vorhergehenden Ansprüche, **dadurch gekennzeichnet, dass** im Linienfokus des Ringsektors (21) des parabolischen Rotationskörpers bzw. im Punktfokus des Ringsektors (9) des Rotationsparaboloids eine Blende (29; 12) vorgesehen ist.

5. Laser nach einem der vorhergehenden Ansprüche, **dadurch gekennzeichnet, dass** dem Ringsektor (9; 21) ein optisches Element mit einer oder mehreren Oberflächen nachgeordnet ist, die den Laserstrahl jeweils in zwei zueinander rechtwinkligen Richtungen formt bzw. formen.

6. Laser nach Anspruch 5, **dadurch gekennzeichnet, dass** das optische Element als Bifokuslinse ausgebildet ist.

7. Laser nach Anspruch 5, **dadurch gekennzeichnet, dass** das optische Element mehrteilig ausgebildet ist.

8. Laser nach Anspruch 7, **dadurch gekennzeichnet, dass** das optische Element durch eine Zylinderlinse (13; 24) und mindestens einen parabolischen Zylinderspiegel (14; 25, 26) gebildet ist.

9. Laser nach einem der vorhergehenden Ansprüche, **dadurch gekennzeichnet, dass** der Ringsektor (9; 21) des parabolischen Rotationskörpers koaxial zur Ringsektorachse des einfallenden Laserstrahls (8) angeordnet ist.

## Claims

1. Laser, comprising a coaxial laser resonator (1) having an annular discharge zone (2) and a ring-segment-shaped decoupling aperture (6) and a device (17;20) for the beam-shaping of the laser beam (8), which leaves the decoupling aperture (6) and which has a ring-segment-shaped beam cross-section, into a laser beam (11) having a rectangular beam cross-section, the device (17;20) having a mirror whose mirror surface is constructed as a ring segment (9;21) of a body of revolution,
**characterised in that**
the mirror surface is constructed as a ring segment (9;21) of a parabolic body of revolution.

2. Laser according to claim 1, **characterised in that** the mirror surface is formed by the convex or the concave surface of the parabolic body of revolution.

3. Laser according to claim 2, **characterised in that** the parabolic body of revolution is in the form of a parabaloid of revolution.

4. Laser according to any one of the preceding claims, **characterised in that** an apertured screen (29;12) is provided at the linear focus of the ring segment (21) of the parabolic body of revolution or at the point focus of the ring segment (9) of the parabaloid of revolution.

5. Laser according to any one of the preceding claims, **characterised in that** an optical element having one or more surfaces is arranged downstream of the ring segment (9;21), which surface(s) shape(s) the laser beam in two directions at right-angles to each other.

6. Laser according to claim 5, **characterised in that** the optical element is in the form of a bifocal lens.

7. Laser according to claim 5, **characterised in that** the optical element is constructed in several pieces.

8. Laser according to claim 7, **characterised in that** the optical element is formed by a cylindrical lens (13;24) and at least one parabolic cylindrical mirror (14;25,26).

9. Laser according to any one of the preceding claims, **characterised in that** the ring segment (9;21) of the parabolic body of revolution is arranged coaxially relative to the ring segment axis of the incident laser beam (8).

## Revendications

1. Laser comprenant un résonateur de laser (1) coaxial avec chambre de décharge (2) en forme d'anneau et ouverture de sortie (6) en forme de secteur annulaire ainsi qu'un dispositif (17 ; 20) de transformation de faisceau permettant de transformer le faisceau laser (8) sortant de l'ouverture de sortie (6) avec section de faisceau en forme de secteur annulaire en un faisceau laser (11) avec section de faisceau en forme de rectangle, le dispositif (17 ; 20) comportant un miroir dont la surface est configurée en secteur annulaire (9 ; 21) d'un corps de révolution, **caractérisé en ce que** la surface de miroir est configurée en secteur annulaire (9 ; 21) d'un corps de révolution parabolique.

2. Laser selon la revendication 1, **caractérisé en ce que** la surface de miroir est formée par la surface convexe ou concave du corps de révolution parabolique.

3. Laser selon la revendication 2, **caractérisé en ce que** le corps de révolution parabolique est configuré en paraboloïde de révolution.

4. Laser selon l'une quelconque des revendications précédentes, **caractérisé en ce qu'**un diaphragme (29 ; 12) est prévu dans le foyer linéaire du secteur annulaire (21) du corps de révolution parabolique ou bien dans le foyer ponctuel du secteur annulaire (9) du paraboloïde de révolution.

5. Laser selon l'une quelconque des revendications précédentes, **caractérisé en ce qu'**un élément optique comportant une ou plusieurs surface(s) est placé après le secteur annulaire (9 ; 21), surface(s) qui forme(nt) le faisceau laser dans deux directions perpendiculaires l'une par rapport à l'autre.

6. Laser selon la revendication 5, **caractérisé en ce que** l'élément optique est configuré en lentille bifocale.

7. Laser selon la revendication 5, **caractérisé en ce que** l'élément optique est configuré en plusieurs parties.

8. Laser selon la revendication 7, **caractérisé en ce que** l'élément optique est formé d'une lentille cylindrique (13; 24) et au moins d'un miroir cylindrique (14 ; 25, 26) parabolique.

9. Laser selon l'une quelconque des revendications précédentes, **caractérisé en ce que** le secteur annulaire (9 ; 21) du corps de révolution parabolique est disposé coaxialement par rapport à l'axe du secteur annulaire du faisceau laser (8) incident.
